# EUROPÄISCHE PATENTSCHRIFT

(11) **EP 0 795 899 B1**
(45) Veröffentlichungstag und Bekanntmachung des Hinweises auf die Patenterteilung: **07.05.2003**
(21) Anmeldenummer: 97103597.7
(22) Anmeldetag: 05.03.1997
(51) Int. Cl.: H01L 21/331, H01L 29/737

(54) **Verfahren zur Herstellung eines Heterobipolartransistors**
Method for fabricating a heterojunction bipolar transistor
Procédé de fabrication d'un transistor bipolaire à hétérojonction

(30) Priorität: 14.03.1996 DE 19609933
(43) Veröffentlichungstag der Anmeldung: 17.09.1997
(73) Patentinhaber: ATMEL Germany GmbH, 74072 Heilbronn (DE)
(72) Erfinder: König, Ulf, Dr., 89075 Ulm (DE); Schüppen, Andreas, Dr., 89075 Ulm (DE); Dietrich, Harry, 74912 Kirchardt (DE)
(74) Vertreter: Maute, Hans-Jürgen, Dipl.-Ing.

(56) Entgegenhaltungen:
- EP-A- 0 507 454
- EP-A- 0 550 962
- EP-A- 0 551 185
- EP-A- 0 607 836
- EP-A- 0 684 639
- DE-A- 4 102 888
- BURGHARTZ J N ET AL: 'APCVD-GROWN SELF-ALIGNED SIGE-BASE HBTS' PROCEEDINGS OF THE BIPOLAR/BICOMS CIRCUITS AND TECHNOLOGY MEETING, MINNEAPOLIS, OCT. 4 - 5, 1993 01 Januar 1993, JOPKE J, Seiten 55 - 62, XP000482242

## Beschreibung

Die Erfindung betrifft ein Verfahren zur Herstellung eines Heterobipolartransistors (HBT).

Ein derartiges Verfahren ist aus der Druckschrift EP 0 684 639 A1 bekannt. Hierbei wird ein Heterobipolartransistor (HBT) für hohe Frequenzen erzeugt, indem mittels eines differentiellen Epitaxieprozesses auf einem Kollektor, der von Isolationsgebieten umgeben ist, eine Basisschicht, eine Emitterschicht, und eine Emitterkontaktschicht aufgewachsen wird. Anschließend wird mittels einer Maske die Emitterkontaktschicht strukturiert und an der Außenkante der Emitterkontaktschicht ein Außenspacer ausgebildet. Ein weiteres Verfahren ist aus der Druckschrift EP 0 607 836 A2 bekannt. Hierbei wird mittels eines Abscheideprozesses unterbrechungsfrei die Kollektorschicht, die Basisschicht, die Emitterschicht und die Emitterkontaktschicht abgeschieden. Nachfolgend wird an der Außenkante ein Außenspacer gebildet. Nachteilig bei beiden Verfahren ist es, daß der zur Strukturierung des Emitters verwendete Trockenätzprozeß auf den aktiven Bereichen durchgeführt und die Leitbasisimplantation erst nach der Bildung des Außenspacers ausgeführt wird.

Ein weiteres Verfahren ist aus der Veröffentlichung von J.N. Burghartz et al. in IEEE, 1993, Bipolar Circuits and Technology Meeting, S. 55-62 bekannt. Hierbei wird nach dem Aufwachsen der HBT-Schichtenfolge mittels einer Maskenöffnung und eines Innenspacers an der Innenseite der Maskenkante die Emitterkontaktschicht abgeschieden und mittels eines ersten CMP-Prozesses planarisiert Ferner verbleiben nach der Entfernung der Maske an dem Fuß der Emitterkontaktschicht kleine Außenspacer. Nachfolgend wird mittels einer Oxidschicht und eines zweiten CMP-Prozesses die Oberfläche planarisiert. Nachteilig ist, daß das Endpunktsignal bei der Ätzung der Nitridschicht aufgrund der geringen offenen Fläche einen sehr kleinen Hub aufweist und die Emitterkontaktschicht durch den zweiten CMP-Schritt gedünnt wird. Ferner verursacht die Mehrfachanwendung eines CMP Prozesses hohe Kosten bei der Herstellung der Bauelemente. Des Weiteren führt die Ausbildung der Basisanschlußschicht nach der Bildung der Außenspacers zu einem erhöhten Anschlußwiderstand.

Das erfindungsgemäße Verfahren findet insbesondere Verwendung bei der Herstellung von SiGe-HBT. Derzeit sind zwei verschiedene Schichtstrukturen von SiGe-HBT's bekannt. Ein HBT mit niedrig dotiertem Si-Emitter und höher dotierter SiGe-Basis mit abrupten rasterförmigem Ge- und Dotierstoffprofilen und ein HBT mit einer Schichtstruktur mit graduierten Ge- und Dotierstoffprofilen wie in Standardbipolartransistoren. Bei letztgenanntem Schichtaufbau können jedoch die Vorteile der Heterostruktur nicht voll genutzt werden, da der Basisschichtwiderstand wie beim Standardbipolartransistor mit der Dicke der Basis skaliert und nicht wie bei dem SiGe-HBT mit kastenförmigem Ge- und Dotierstoffprofilen fast unabhängig von der Basisdicke ist. Dies schlägt sich vor allem in den maximalen Schwingfrequenzen nieder, die bei der erstgenannten Variante weitaus höher liegen als bei der zweiten Variante.

Nachteilig bei dem SiGe-HBT mit kastenförmigen Ge- und Dotierstoffprofilen ist jedoch, daß aufgrund der steilen Geund Dotierstoffprofile die Struktur sehr sensibel auf Temperungen, Implantationen und thermische Oxidationen reagiert und deshalb eine Doppelmesastruktur am vorteilhaftesten ist. Die Mesastruktur des Emitters hat jedoch den Nachteil, daß der Abstand zwischen den die Leitbasis mitbildende Silizid und dem Leitbasis/Emitter-Übergang durch einen Doppelspacer definiert werden muß. Bei dieser Doppelspacertechnologie sind hohe Implantationsenergien notwendig, die zu Defekten in der Basis führen und somit die Schichtqualität und die Transistoreigenschaften nachteilig beeinflussen.

Darüberhinaus war es bisher nicht möglich, einen Poly-Si-Emitter auf einem HBT mit kastenförmigen Ge- und Dotierstoffprofilen zu realisieren, da dann eine Ausdiffusion des Dotierstoffs (z.B. Bor) aus der Basis in Gang gesetzt wird.

Aufgabe der Erfindung ist deshalb ein Verfahren zur Herstellung eines Heterobipolartransistors, das für eine Massenproduktion geeignet ist und mit dem produkttaugliche HBT's mit guten Schichtqualitäten und geringen Kontaktwiderständen herstellbar sind.

Diese Aufgabe wird gelöst durch das Verfahren gemäß Patentanspruch 1. Vorteilhafte Ausgestaltungen und/oder Weiterbildungen sind den Unteransprüchen zu entnehmen.

Die Erfindung hat den Vorteil, daß durch einen Exside-Inside-Spacer-Prozeß mit einem amorphen Si-Emitter die oben aufgeführten Nachteile beseitigt werden. Es können in vorteilhafterweise Standardlithographieverfahren zur selbstjustierenden Herstellung von Emitterbreiten bis zu ca. 0,3µm eingesetzt werden. Weiterhin entfällt die Si-Mesaätzung des Emitters, dadurch findet die Passivierung des Bauelements an einer sauberen Oberfläche statt. Da bei dem vorliegenden Verfahren weitaus geringere Implantationsenergien als bei der Doppelspacertechnologie notwendig sind, werden hohe Schichtqualitäten erreicht und die Transistoreigenschaften verbessert.

Durch die Verwendung eines Exside-Inside-Spacers kann der Abstand zwischen Leitbasis/Emitter-Übergang und das die Basiszuleitung mitbildende Silizid genau eingestellt werden und dadurch Kurzschlüsse vermieden werden.

Vorteilhaft ist auch die Verwendung von Phosphor bei der Dotierung des amorphen Si-Emitterkontaktes und die anschließende Kurzzeittemperung bei Temperaturen von mehr als 900°C, da dadurch die Ausdiffusion von Bor aus der Basis verhindert wird. Außerdem hat Phosphor dotiertes amorphes Silizium einen sehr geringen Widerstand.

Die Erfindung wird im folgenden anhand eines Ausführungsbeispieles beschrieben unter Bezugnahme auf schematische Zeichnungen.

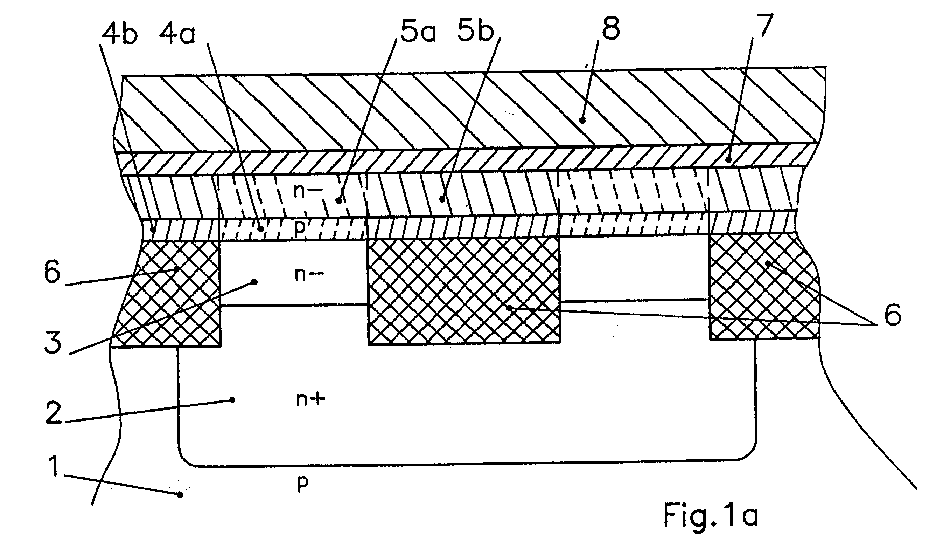

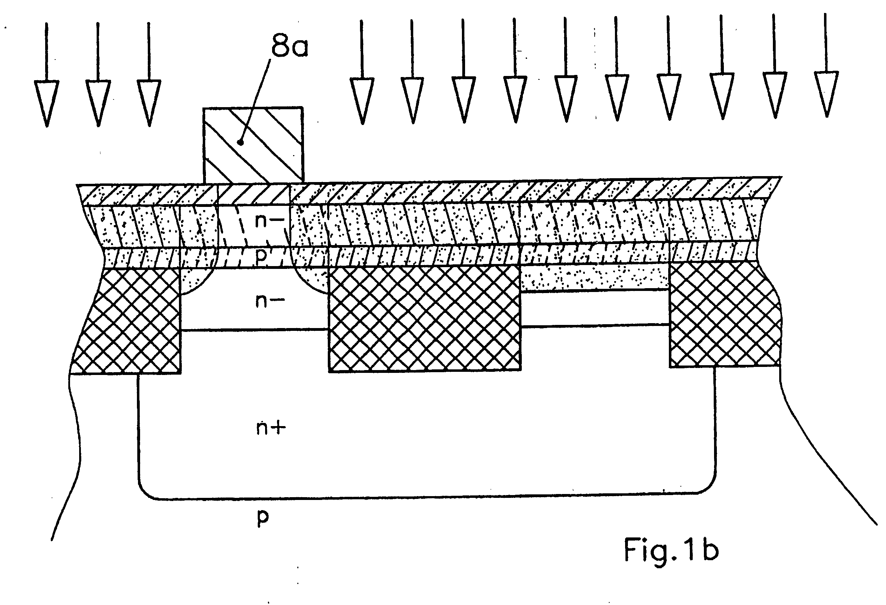

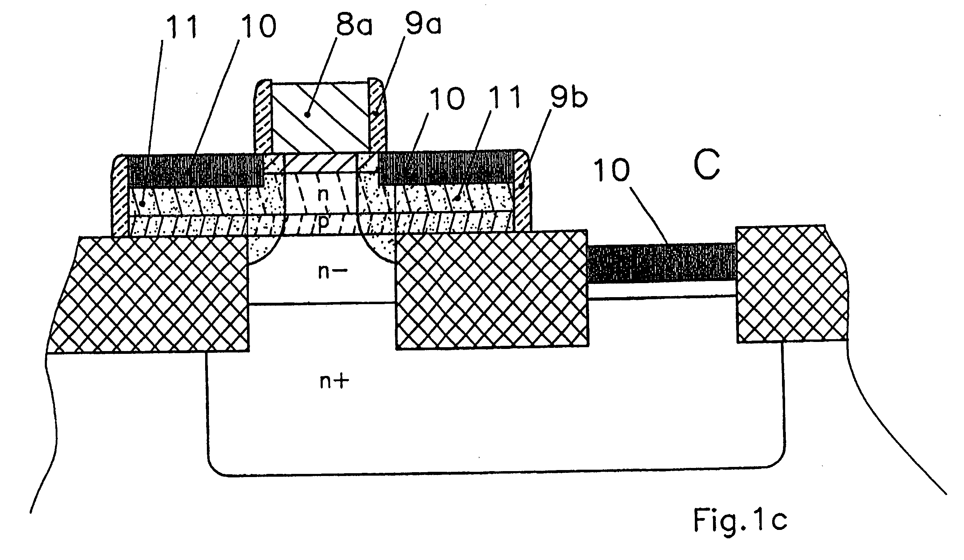

In den Fig. 1a bis 1f ist an einem Ausführungsbeispiel der Verfahrensablauf dargestellt. Zur Herstellung des differentiellen HBT wird beispielsweise gemäß FIG. 1a in einem p-dotierten Si-Substrat eine n⁺-dotierte Wanne 2 als Kollektorzuleitungsschicht ausgebildet. Auf das Substrat 1 mit Wanne 2 wird eine erste Schicht, die Kollektorschicht 3 aus z.B. n⁻-dotiertem Si epitaktisch gewachsen. In diese erste Schicht werden z.B. durch photolithographische Strukturierung und lokale Oxidation des Siliziummaterials (LOCOS oder recessed LOCOS) Isolationsgebiete 6 erzeugt, die vorzugsweise bis in das Substrat 1 bzw. Wanne 2 reichen. Außerdem ist es möglich mittels selektiv einfüllender Epitaxie in einer auf einem Substrat 1 mit Wanne 2 hergestellten Struktur aus Isolationsgebieten 6 eine erste Schicht, die Kollektorschicht 3 aus n⁻-dotiertem Si aufzuwachsen. Derartige Verfahren sind z.B. in der DE 44 17 916 angegeben. Auf eine derartige Struktur wird z.B. eine p-dotierte SiGe-Schicht und eine n-dotierte Si-Schicht mit einem differentiellen Epitaxie-Verfahren (MBE oder CVD) abgeschieden (FIG. 1a). Dabei wächst monokristallines Halbleitermaterial in den Bereichen zwischen den Isolationsgebieten 6, die z.B. aus SiO₂ hergestellt sind, und polykristallines Halbleitermaterial auf dem SiO₂. Es bilden sich die monokristallinen Bereiche bestehend aus den SiGeund Si-Schichten 4a, 5a die die Basis-Schicht 4a und die Emitterschicht 5a bilden, und polykristalline SiGe- und Si-Schichten 4b, 5b. Diese Schichtenfolge wird thermisch oxidiert. Anschließend wird eine Doppelschicht 7, 8 aus z.B. SiO₂ und Si₃N₄ aufgebracht (FIG. 1a). Aus der Si₃N₄-Schicht 8 wird mit einem Lithographieschritt und einer Plasmaätzung eine Emittermaske 8a hergestellt (FIG. 1b). Durch eine nachfolgende Implantation z.B. mit bei BF₂ 40keV und einer Flächendotierung von 6·10¹⁵cm⁻² erfolgt eine Umdotierung der Schichtenfolge, derart, daß lediglich der durch die Maske 8a abgedeckte Teil nicht davon betroffen wird (FIG. 1b). Die Grenzen zwischen poly- und monokristallinem Material sind bei der Umdotierung miteingeschlossen. Anschließend wird eine Kurzzeittemperung durchgeführt und über geeignete Ätz- und Lithographieverfahren wird die Leitbasis 11 und der Kollektoranschluß C strukturiert (FIG. 1c). Es werden an der Emittermaske 8a und an den senkrechten Flanken der Leitbasis 11 Spacer 9a, 9b aus z.B. SiO₂ erzeugt (FIG. 1c). Nachfolgend wird eine Metallschicht z.B. Ti abgeschieden und es bildet sich im Bereich der Leitbasis und dem Kollektoranschluß C eine Silizidschicht 10. Durch die Spacer 9a, 9b erfolgt die Silizidbildung selbstjustierend. Der Abstand zwischen Leitbasis/Emitter Übergang und der Silizidschicht wird durch den Spacer 9a definiert. Die Ti-Schicht wird außer im Basisund Kollektorbereich wieder entfernt.

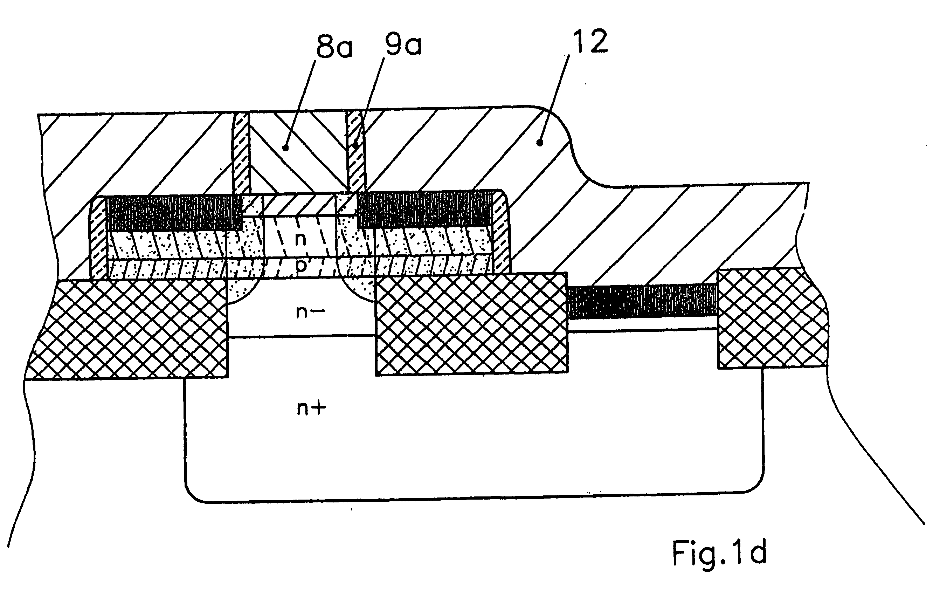

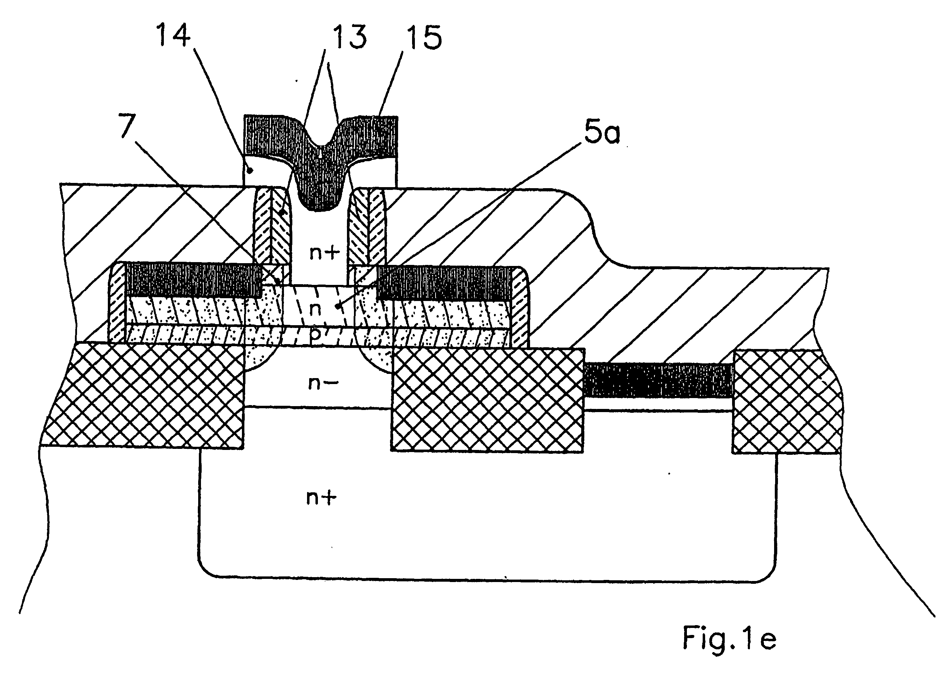

Anschließend wird eine SiO₂-Schicht 12 ganzflächig abgeschieden und mittels Politurätzung (chemical mechanical polishing (CMP)) das Emitterfenster wieder geöffnet (FIG. 1d). Durch einen nachfolgenden naßchemischen Ätzprozeß wird die Maske 8a im Fensterbereich entfernt und es wird ein Inside-Spacer 13 aus z.B. poly-Si oder einer Kombination aus dünnem Nitrid und poly Si gebildet (FIG. 1e). Dabei ist es von entscheidender Bedeutung, daß die für die Spacer-Herstellung notwendige Plasmaätzung auf der Oxidschicht 7 stoppt, so daß die Emitterschicht 5a nicht von der Plasmaätzung beeinflußt wird. Der Inside-Spacer definiert die Emitterbreite und es lassen sich Emitterbreiten z.B. von etwa 0,4µm realisieren.

Die Oxidschicht 7 im Emitterbereich wird anschließend naßchemisch entfernt. Es wird amorphes Si zur Bildung einer Emitterkontaktschicht 14 abgeschieden. Zur Herstellung einer n⁺-dotierten Emitterkontaktschicht 14 wird das amorphe Si mit Phosphor dotiert und nachfolgend ein Kurzzeitausheilschritt durchgeführt. Dieser Kurzzeitausheilschritt findet bei einer Temperatur von mehr als 900°C statt. Der Emitterkontakt wird strukturiert und es kann noch zusätzlich auf der amorphen Si-Schicht selektiv zum SiO₂ eine Silizidschicht 15, z.B. mit Ti, ausgebildet werden (FIG. 1e). Bei einer derartigen Emitterkontaktherstellung treten keinerlei Probleme beim Übergang von der amorphen Si-Kontaktschicht 14 zur monokristallinen n-Emitterschicht 5a auf, da die monokristalline Emitterschicht 5a nicht einem Plasmaätzprozeß ausgesetzt wird und eine gute Schichtqualität besitzt. Außerdem ist vorteilhaft, daß der aktive Basis/Emitter Übergang nicht durch Ausdiffusion aus dem amorphen Si bestimmt wird, sondern lediglich durch die Dotierungsverhältnisse während des Epitaxieverfahrens.

Da die Temperaturen der Kurzzeitausheilschritte bei mehr als 900°C liegen können, was oberhalb der zulässigen Temperatur für metastabile SiGe-Schichten liegt, ist das erfindungsgemäße Verfahren temperaturstabiler als bekannte Verfahren der Bipolarherstellung.

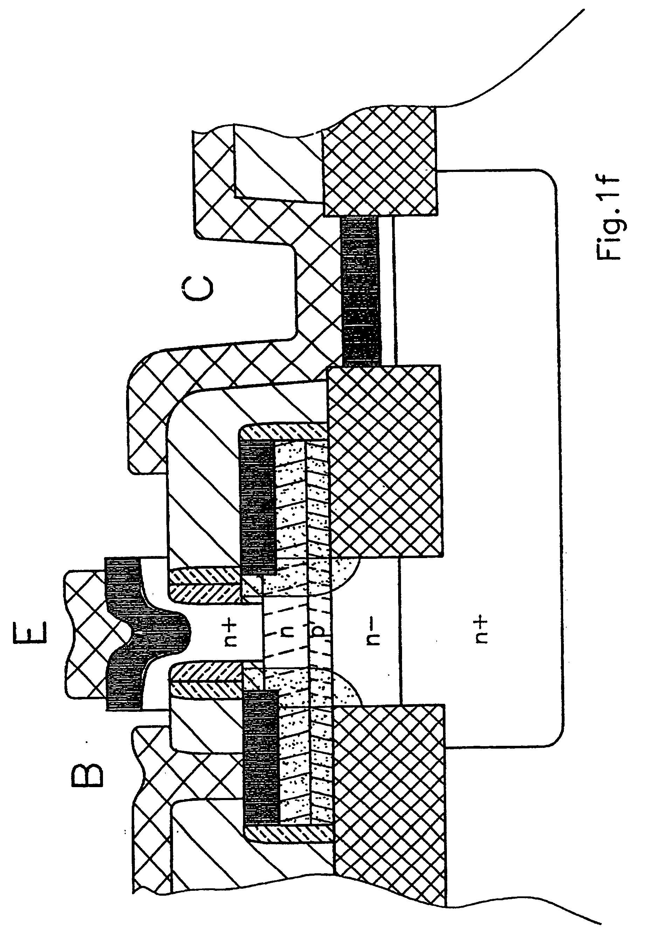

Es folgt anschließend das öffnen der Kontaktlöcher für den Basis- und Kollektoranschluß und eine Standardmetallisierung zur Herstellung der Kontakte C, B, E (FIG. 1f).

Die Erfindung ist nicht auf die im Detail beschriebene Herstellung eines npn-HBT beschränkt, sondern auf komplementäre Dotierung und auf gewöhnliche Bipolartransistoren in analoger Weise anwendbar. Das Halbleitermaterial ist nicht auf Si und SiGe beschränkt. Insbesondere können auch III/V-Halbleiterverbindungen zum Einsatz kommen.

Ein typischer Aufbau für einen nach der Erfindung hergestellten SiGe-HBT wird im folgenden Zahlenbeispiel angegeben:
- ein p-Si-Substrat 1 mit einem spezifischen Widerstand von 20Ωcm
- eine Si-Kollektorzone 2 mit einem Schichtwiderstand von 10Ω/Flächeneinheit
- eine Si-Kollektorschicht 3 mit einer n⁻-Dotierkonzentration von 1·10¹⁶ bis 5·10¹⁷cm⁻³ und einer Schichtdicke von 200nm bis 1000nm.
- eine SiGe-Basisschicht 4a mit einer p-Dotierkonzentration von 2·10¹⁹cm⁻³ und einer Schichtdicke von 40nm
- eine Si-Emitterschicht 5a mit einer n-Dotierkonzentration von 2·10¹⁸cm⁻³ und einer Schichtdicke von 70nm
- einer amorphen Si-Emitterkontaktschicht 14 mit einer Schichtdicke von 150nm und einer Phosphorimplantation von 1·10¹⁶cm⁻² bei 20keV
- Exside-Spacer mit einer Breite von 150nm
- Inside-Spacer mit einer Breite von 100nm
- Silizidschichten aus TiSi₂ mit einer Schichtdicke von 50nm
- eine Metallisierung der Kontakte C,B,E mit einer AlTiSi-oder AlSiCu-Schicht mit einer Schichtdicke von 1µm.

Desweiteren ist es vorteilhaft zur Herstellung einer Kollektorschicht 3, nach der Inside-Spacerätzung durch die Emitteröffnung ohne weitere Maske eine zusätzliche Dotierung z.B. mit Phosphor mit einer Flächendotierung von 5 · 10¹²cm⁻² bei 100keV durchzuführen (selektiver implantierter Kollektor).

## Patentansprüche

1. Verfahren zur Herstellung eines Heterobipolartransistors, bei dem auf einer monokristallinen Zuleitungsschicht (2) eine erste strukturierte Schicht mit einer monokristallinen Kollektorzone (3), die von Isolationsgebieten (6) umgeben ist, erzeugt wird und mittels differentieller Epitaxie aufliegend auf der ersten Schicht, eine zweite Schicht mit einer monokristallinen Basiszone (4a), die von polykristallinen Gebieten (4b) umgeben ist, und auffliegend auf der zweiten Schicht eine Oberfläche bildende dritte niedrig dotierte Schicht mit einer monokristallinen Emitterzone (5a), die von polykristallinen Gebieten (5b) umgeben ist, aufgewachsen wird, wobei
• zur Ausbildung einer Maske (8a), mit der ein Teil der Oberfläche der Emitterzone (5a) abgedeckt wird, auf die dritte Schicht eine Oxidschicht (7) und eine auf der Oxidschicht (7) aufliegende Nitridschicht (8) aufgebracht wird und die Nitridschicht (8) mittels eines Lithographie- und Ätzschrittes strukturiert wird,
• die die Maske (8a) umgebenden Gebiete der dritten Schicht durch eine Umdotierung vollständig als Basiszuleitung (11) derart ausgebildet werden, dass bei der Umdotierung die Grenzen zwischen polykristallinen Gebieten (5b) und monokristalliner Emitterzone (5a) mit eingeschlossen sind,
• die Basiszuleitung (11) so strukturiert wird, dass seitliche Flanken der Basiszuleitung (11) gebildet werden,
• an den seitlichen senkrechten Flanken der Maske (8a) und den seitlichen Flanken der Basiszuleitung (11) Oxid-Außenspacer (9a ,9b) ausgebildet werden,
• selbsjustierend zu der Emitterzone (5a) die den Oxid-Außenspacer (9a) umgebenden Gebiete der dritten Schicht der Basiszuleitung (11) teilweise in Silizid umgewandelt werden,
• zur Ausbildung eines Innenspacers (13) der aus Nitrid bestehende Teil der Maske (8a) selektiv zu der unterliegenden Oxidschicht (7) entfernt wird,
• an der seitlichen Innenkante des Oxid-Außenspacers (9a) ein Innenspacer (13) ausgebildet wird, und nachfolgend die Oxidschicht (7) entfernt wird, und
• zur Herstellung des Emitterkontaktes auf der durch den Innenspacer (13) abgegrenzten Oberfläche der Emitterzone (5a) ein hochdotiertes amorphes Halbleitermaterial als Emitterkontaktschicht (14) abgeschieden wird.

2. Verfahren nach Anspruch 1, **dadurch gekennzeichnet, daß** als zweite Schicht eine p-dotierte SiGe-Schicht und als dritte Schicht eine gering n-dotierte Si-Schicht aufgewachsen wird.

3. Verfahren nach Anspruch 1, **dadurch gekennzeichnet, daß** bei der Ausbildung der Maske (8a) die unter der Nitridschicht (8) liegende Oxidschicht (7) in den die Maske (8a) umgebenden Gebieten erhalten bleibt.

4. Verfahren nach Anspruch 3, **dadurch gekennzeichnet, daß** zur Ausbildung der Basiszuleitung (11) eine BF2-Implantation durch die Oxidschicht (7) durchgeführt wird.

5. Verfahren nach Anspruch 3, **dadurch gekennzeichnet, daß**
• zum Entfernen der Maske (8a) die gesamte Struktur mit einem Oxid (12) abgedeckt und mittels einer Politurätzung die Oberfläche der Maske (8a) freigelegt wird,
• der aus Nitrid bestehende Teil der Maske (8a) mittels eines naßchemischen Prozesschrittes selektiv zu der Oxidschschicht (7) entfernt wird, und
• vor dem Abscheiden der Emitterkontaktschicht (14), die vorzugsweise aus einem hochdotierten amorphen Silizium besteht, die als Teil der Maske (8a) auf der Emitterzone (5a) aufliegende Oxidschicht (7) naßchemisch entfernt wird.

6. Verfahren nach Anspruch 1 oder 5, **dadurch gekennzeichnet, daß** die Emitterkontaktschicht (14) eine größere Fläche als die Maske (8a) aufweist und die Emitterkontaktschicht (14) mit Phosphor, vorzugsweise bei einer Dosis von 10e16 cm-2 und bei einer Energie von 20 keV, implantiert wird.

7. Verfahren nach Anspruch 1 oder 5, **dadurch gekennzeichnet, daß** auf der Emitterkontaktschicht (14) eine Silizidschicht (15) ausgebildet wird.

8. Verfahren nach Anspruch 6, **dadurch gekennzeichnet, daß** ein Kurzzeitausheilschritt bei einer Temperatur oberhalb 900°C durchgeführt wird.

## Claims

1. Method of producing a heterobipolar transistor in which a first structured layer with a monocrystalline collector zone (3) surrounded by insulation regions (6) is produced on a monocrystalline conductor layer (2) and a second layer with a monocrystalline base zone (4a) surrounded by polycrystalline regions (4b) is grown by means of differential epitaxy to lie on the first layer and a third low-doped layer with a monocrystalline emitter zone (5a) surrounded by polycrystalline regions (5b) is grown by means of differential epitaxy to lie on the second layer and form a surface, wherein
- for formation of a mask (8a), by which a part of the surface of the emitter zone (5a) is covered, an oxide layer (7) is applied to the third layer and a nitride layer is applied to lie on the oxide layer (7) and the nitride layer (8) is structured by means of a lithography step and etching step,
- the regions, which surround the mask (8a), of the third layer are formed, by a redoping, completely as a base conductor (11) in such a manner that in the redoping the boundaries between polycrystalline regions (5b) and monocrystalline emitter zone (5a) are included therewith,
- the base conductor (11) is so structured that lateral flanks of the base conductor (11) are formed,
- oxide outer spacers (9a, 9b) are formed at the lateral vertical flanks of the mask (8a) and the lateral flanks of the base conductor (11),
- the regions, which surround the oxide outer spacer (9a), of the third layer of the base conductor (11) are partly converted into silicide in a manner self-adjusting with respect to the emitter zone (5a),
- for formation of an inner spacer (13) the part of the mask (8a) consisting of nitride is removed selectively with respect to the underlying oxide layer (7),
- an inner spacer (13) is formed at the lateral inner edge of the oxide outer spacer (9a) and the oxide layer (7) is subsequently removed and
- a high-doped amorphous semiconductor material as an emitter contact layer (14) is precipitated for producing the emitter contact on the surface, which is bounded by the inner spacer (13), of the emitter zone (5a).

2. Method according to claim 1, **characterised in that** a p-doped SiGe layer is grown as second layer and a low n-doped Si layer is grown as third layer.

3. Method according to claim 1, **characterised in that** in the formation of the mask (8a) the oxide layer (7) lying under the nitride layer (8) is maintained in the region surrounding the mask (8a).

4. Method according to claim 3, **characterised in that** a BF₂ implantation is carried out through the oxide layer (7) for formation of the base conductor (11).

5. Method according to claim 3, **characterised in that**
- for removal of the mask (8a) the entire structure is covered with an oxide (12) and the surface of the mask (8a) is exposed by means of a polish-etching of the surface of the mask (8a),
- the part of the mask (8a) consisting of nitride is selectively removed with respect to the oxide layer (7) by means of a wet-chemical process step and
- before precipitation of the emitter contact layer (14), which preferably consists of a high-doped amorphous silicon, the oxide layer (7) lying as part of the mask (8a) on the emitter zone (5a) is removed by wet-chemical procedure.

6. Method according to claim 1 or 5, **characterised in that** the emitter contact layer (14) has a greater area than the mask (8a) and the emitter contact layer (14) is implanted with phosporous, preferably at a dose of 10e16 cm⁻² and at an energy of 20 keV.

7. Method according to claim 1 or 5, **characterised in that** a silicide layer (15) is formed on the emitter contact layer (14).

8. Method according to claim 6, **characterised in that** a brief curing step is carried out a temperature above 900° C.

## Revendications

1. Procédé de fabrication d'un transistor hétérobipolaire, dans lequel on crée, sur une couche conductrice (2) monocristalline une première couche structurée présentant une zone collectrice (3) monocristalline, entourée de régions d'isolement (6) et on réalise par croissance épitaxiale différentielle appliquée sur la première couche une deuxième couche présentant une zone de base (4a) monocristalline entourée de régions (4b) polycristallines, et appliquée sur la deuxième couche une troisième couche faiblement dopée formant une surface présentant une zone émettrice (5a) monocristalline, entourée de régions (5b) polycristallines, dans lequel :
. on applique sur la troisième couche une couche d'oxyde (7) et une couche de nitrure (8) appliquée sur la couche d'oxyde (7) et on structure la couche de nitrure (8) en utilisant une technique de lithographie et d'enlevage pour former un masque (8a) avec lequel on recouvre une partie de la surface de la zone émettrice (5a),
. on conforme les régions de la troisième couche entourant le masque (8a) par dédopage entièrement en alimentation de base (11) de telle façon que lors du dédopage les limites entre régions polycristallines (5b) et zone émettrice (5a) monocristalline soient incluses,
. on structure l'alimentation de base (11) de telle façon que l'on constitue des flancs latéraux de l'alimentation de base (11),
. on conforme sur les flancs latéraux verticaux du masque (8a) et les flancs latéraux de l'alimentation de base (11) de l'oxy-espaceur extérieur (9a, 9b),
. les régions de la troisième couche de l'alimentation de base (11) entourant l'oxy-espaceur (9a), à ajustage automatique par rapport à la zone émettrice (5a), sont partiellement transformées en siliciure,
. pour former un espaceur intérieur (13) on enlève la partie du masque (8a) consistant en nitrure sélectivement par rapport à la couche d'oxyde (7) sous-jacente,
. on forme sur le bord intérieur latéral de l'oxy-espaceur extérieur (9a) un espaceur intérieur (13), et on enlève ensuite la couche d'oxyde (7), et
. on sépare un matériau semi-conducteur hautement dopé amorphe comme couche de contact émettrice (14) pour réaliser le contact émetteur sur la surface de la zone émettrice (5a) délimitée par l'espaceur intérieur (13).

2. Procédé selon la revendication 1, **caractérisé en ce que** l'on réalise par épitaxie une couche de SiGe dopée p comme deuxième couche et une couche de Si dopée faiblement n comme troisième couche.

3. Procédé selon la revendication 1, **caractérisé en ce que** lors de la conformation du masque (8a) la couche d'oxyde (7) située sous la couche de nitrure (8) est conservée dans les régions entourant le masque (8a).

4. Procédé selon la revendication 3, **caractérisé en ce que** l'on forme une implantation BF2 à travers la couche d'oxyde (7) pour constituer l'alimentation de base (11).

5. Procédé selon la revendication 3, **caractérisé en ce que** :
. pour enlever le masque (8a), on recouvre l'ensemble de la structure d'un oxyde (12) et l'on dénude la surface du masque (8a) par polissage mécano-chimique,
. on enlève la partie du masque (8a) consistant en nitrure au moyen d'un procédé chimique humide sélectivement par rapport à la couche d'oxyde (7), et
. avant la séparation de la couche de contact émettrice (14), consistant de préférence en un silicium amorphe hautement dopé, on enlève la couche d'oxyde (7) appliquée comme partie du masque (8a) sur la zone émettrice (5a) par un procédé chimique humide.

6. Procédé selon la revendication 1 ou 5, **caractérisé en ce que** la couche de contact émettrice (14) présente une superficie supérieure à celle du masque (8a) et **en ce que** l'on implante du phosphore dans la couche de contact émettrice (14), de préférence à une dose de 10e16 cm-2 et à une énergie de 20 keV.

7. Procédé selon la revendication 1 ou 5, **caractérisé en ce que** l'on constitue sur la couche de contact émettrice une couche de siliciure (15).

8. Procédé selon la revendication 6, **caractérisé en ce que** l'on effectue une étape de régénération de courte durée à une température supérieure à 900°C.
